(19) Europäisches Patentamt
European Patent Office
Office européen des brevets

(11)     EP 3 260 573 B1

(12)     EUROPEAN PATENT SPECIFICATION

(45) Date of publication and mention
of the grant of the patent:
**02.10.2019  Bulletin 2019/40**

(51) Int Cl.:
*C23C 16/44* (2006.01)       *C23C 8/28* (2006.01)
*C23C 8/02* (2006.01)        *C23C 8/34* (2006.01)
*C23C 8/80* (2006.01)        *C23C 10/02* (2006.01)
*C23C 10/08* (2006.01)       *C23C 10/60* (2006.01)
*C23C 12/00* (2006.01)       *C23C 12/02* (2006.01)
*C23C 16/24* (2006.01)       *C23C 16/46* (2006.01)
*H05B 3/12* (2006.01)        *H05B 3/14* (2006.01)
*H05B 3/54* (2006.01)

(21) Application number: **16752606.0**

(22) Date of filing: **16.02.2016**

(86) International application number:
**PCT/JP2016/054969**

(87) International publication number:
**WO 2016/133220 (25.08.2016 Gazette 2016/34)**

(54) **HEAT GENERATION ELEMENT AND METHOD FOR PRODUCING THE SAME**

WÄRMEERZEUGUNGSELEMENT UND VERFAHREN ZUR HERSTELLUNG DAVON

ÉLÉMENT DE GÉNÉRATION DE CHALEUR ET PROCÉDÉ DE FABRICATION ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.02.2015  JP 2015029392**

(43) Date of publication of application:
**27.12.2017  Bulletin 2017/52**

(73) Proprietor: **Kirin Company Limited
Tokyo 164-0001 (JP)**

(72) Inventors:
• **TABUCHI, Hiroyasu**
**Tokyo 164-0001 (JP)**
• **AMANO, Tsutomu**
**Tokyo 164-0001 (JP)**
• **NAKAYA, Masaki**
**Tokyo 164-0001 (JP)**

(74) Representative: **Hoffmann Eitle
Patent- und Rechtsanwälte PartmbB
Arabellastraße 30
81925 München (DE)**

(56) References cited:
**EP-A1- 2 660 049        EP-A1- 2 660 353
EP-A1- 3 284 846        WO-A1-2006/126677
WO-A1-2009/021199      WO-A1-2012/091095
JP-A- 2013 022 923**

## Description

Technical Field

The present disclosure relates to a heat generation element and a method of manufacturing the same.

Background Art

A heat generation element chemical vapor deposition (CVD) method has been known as one of film formation methods. The heat generation element CVD method is also referred to as a Cat-CVD method or a hot wire CVD method, and is a method of decomposing material gas by bringing material gas into contact with a heat generation element, which is caused to generate heat, and depositing generated chemical species as a thin film on a surface of an evaporated object directly or after a reaction process in a gas phase (for example, see Patent Literature 1).

Metallic tantalum has been widely used as the heat generation element. However, metallic tantalum has weak creep strength at a high temperature and is inferior in durability. It is known that durability is enhanced by carbonizing a surface of metallic tantalum. A technology of installing a tantalum wire made of tantalum in a chamber, introducing a carbon source into the chamber, and electrifying and heating the tantalum wire, thereby forming a peripheral portion made of tantalum carbide on a surface of the tantalum wire has been disclosed as a carbonizing method (for example, see Patent Literature 2). In addition, a method of removing a natural oxide film formed on a tantalum surface in a vacuum heat treatment furnace, and then introducing a carbon source into the vacuum heat treatment furnace to perform heat treatment, thereby forming carbide of tantalum from the tantalum surface (for example, see Patent Literature 3). Since there is a disadvantage that a completely carbonized tantalum wire is significantly fragile to the extent that a general operation accompanying physical contact may not be performed, handling can be facilitated by converting at least a part of tantalum into tantalum carbide (for example, see Patent Literature 4). Moreover, Patent Literatures 5 and 6 disclose methods for producing gas barrier plastic molded bodies by using heat generation elements comprising tantalum.

Citation List

Patent Literature

Patent Literature 1: WO 2012/091095 A
Patent Literature 2: JP 2012-41576 A
Patent Literature 3: JP 2005-68002 A
Patent Literature 4: JP 2010-530604 W
Patent Literature 5: EP 2 660 353 A1
Patent Literature 6: EP 2 660 049 A1

Summary of Invention

Technical Problem

For example, the heat generation element is required to be repeatedly used to make the heat generation element CVD method available in a production line of coating of a plastic bottle, etc. However, as a result of keen verification by the inventors, the heat generation elements of Patent Literatures 2 and 3 may not withstand film formation repeated 2,000 times, and a heat generation element having enhanced durability is desired. In addition, when the heat generation element is fully carbonized, the heat generation element becomes fragile and attachment to a film forming apparatus is difficult as described above. In the case of partial carbonization using hydrocarbon gas such as methane as in Patent Literature 2 or 3, since a coefficient of thermal expansion is different between tantalum carbide and metallic tantalum, when a heating time for the heat generation element is extended, or when a temperature rise and fall of the heat generation element is repeated due to a repeated film formation process, peeling may occur or a void may be generated around an interface between tantalum carbide and metallic tantalum. A shape of the heat generation element is easy to be greatly deformed when such peeling occurs or such a void is generated, and excessive heating is likely to locally occur when electrifying and heating are performed, thereby causing a physical/thermal problem.

An object of the disclosure is to provide a heat generation element having high durability and a method of manufacturing the same.

Solution to Problem

A heat generation element according to the present invention includes: a first layer corresponding to a core of the heat generation element and having a metallic tantalum phase; and a second layer which covers a periphery of the first layer and has a tantalum carbide phase, wherein an interface portion is a region including an outer peripheral portion of the first layer and an inner peripheral portion of the second layer, a concentration of silicon in the interface portion is higher than a concentration of silicon in a portion other than the interface portion.

In the heat generation element according to the present invention, a concentration of silicon in an inner peripheral portion of the second layer is preferably larger than a concentration of silicon in a portion other than the inner peripheral portion.

In the heat generation element according to the present invention, a ratio of a cross-sectional area of the first layer to a cross-sectional area of the heat generation element is preferably 0.07 or more and 0.64 or less.

A method of manufacturing the heat generation element according to the present invention includes: an installation step of installing a base material containing tantalum as a main component in a vacuum chamber; and a heating step of introducing a silicon-containing hydrocarbon gas into the vacuum chamber, heating the base material installed in the vacuum chamber, and introducing a silicon atom from an outer surface of the base material into an inside of the base material, wherein the base material is heated at a temperature of 1,600°C or more and less than 2,400°C in the heating step and the heating time is 500 seconds or more and 3,000 seconds or less.

In the method of manufacturing a heat generation element according to present invention, the base material preferably has a wire shape or a ribbon shape, and the base material installed in the vacuum chamber is preferably electrified and heated in the heating step.

Advantageous Effects of Invention

The disclosure provides a heat generation element having high durability and a method of manufacturing the same.

Brief Description of Drawings

Fig. 1 is a cross-sectional view illustrating an example of a heat generation element according to the present embodiment.

Fig. 2 is a schematic configuration diagram of a manufacturing apparatus used for a method of manufacturing the heat generation element according to the present embodiment.

Fig. 3 is a picture illustrating a state of the heat generation element after repeated film formation.

Fig. 4 illustrates section states and secondary ion mass spectrometry (SIMS) analysis results of heat generation elements.

Fig. 5 illustrates a section state and an SIMS analysis result of a heat generation element of Example 4.

Description of Embodiments

The invention will be described in detail with reference to embodiments.

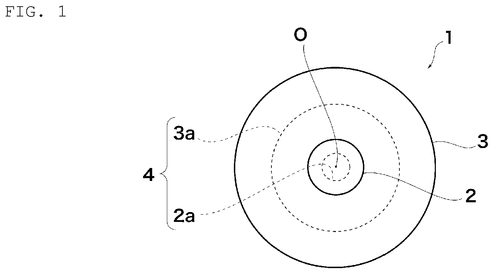

Fig. 1 is a cross-sectional view in a direction perpendicular to a direction in which carburizing is in progress illustrating an example of a heat generation element according to the present embodiment. The direction perpendicular to the direction in which carburizing is in progress refers to a diameter direction of a wire when the heat generation element corresponds to the wire. A heat generation element 1 according to the present embodiment includes a first layer 2 having a metallic tantalum phase and a second layer 3 which covers a periphery of the first layer 2 and has a tantalum carbide phase, and a concentration of silicon in an interface portion 4 between the first layer 2 and the second layer 3 is higher than a concentration of silicon in a portion other than the interface portion 4. When silicon having a high concentration is disposed in the interface portion as described above, it is possible to obtain a heat generation element resistant to long-term and/or repeated heat generation. The presence of each layer may be identified by a rapid change in concentration of carbon and may be easily identified by contrast in observation images of a scattering electron microscope (SEM) or a transmission electron microscope (TEM).

The first layer 2 corresponds to a center (core) of the heat generation element 1 and has a metallic tantalum phase. The first layer 2 is a layer having more metallic tantalum phase than the tantalum carbide phase. For example, the metallic tantalum phase is tantalum, a tantalum-based alloy, or tantalum or a tantalum-based alloy containing an additive. In the tantalum-based alloy, for example, it is preferable that metal forming the alloy with tantalum is at least one of tungsten, niobium, iridium, chromium, hafnium and molybdenum. The tantalum-based alloy preferably contains tantalum in an amount of 80 atom% or more. The additive contained in tantalum or the tantalum-based alloy is, for example, an oxide such as zirconia, yttria, calcia, silica, etc. An addition amount of the additive is preferably 1% by mass or less.

In the heat generation element 1 according to the present embodiment, a ratio of a cross-sectional area of the first layer 2 to a cross-sectional area of the heat generation element 1 is preferably in a range of 0.07 or more and 0.64 or less. By adopting this range, the heat generation element 1 is appropriately carburized, and it is possible to enhance the durability. In addition, it is possible to suppress thermal deformation of the heat generation element at the time of heating, and to impart mechanical strength to the heat generation element allowing attachment to and detachment from other mechanical parts and electrical parts by physical contact. When the ratio is less than 0.07, flexibility of the heat generation element is impaired and handling may become difficult in some cases. When the ratio exceeds 0.64, slight deformation may occur depending on the number of repetitions. The ratio is more preferably 0.07 or more and 0.47 or less. The ratio is even more preferably 0.07 or more and 0.24 or less. In the present specification, a cross section of the heat generation element 1 refers to a surface cut by a plane orthogonal to an axial direction (longitudinal direction) of the heat generation element 1.

The second layer 3 is a peripheral portion of the heat generation element 1 and has a tantalum carbide phase. The second layer 3 is a layer having more tantalum carbide phase than the metallic tantalum phase. The second layer 3 may have a $Ta_2C$ layer and a TaC layer in this order from a side of the first layer 2 toward the outside. The $Ta_2C$ layer is a layer containing more $Ta_2C$ than TaC. The TaC layer is a layer containing more TaC than $Ta_2C$. It is preferable that the $Ta_2C$ layer and the TaC layer have a graded composition.

The interface portion 4 is a region including an outer peripheral portion 2a of the first layer 2 and an inner peripheral portion 3a of the second layer 3. When a distance from a center O of the first layer 2 to an interface between the first layer 2 and the second layer 3 is divided into n equal parts (n is an integer of 2 or more) over a whole circumference to divide the first layer 2 into n regions in a cross section of the heat generation element 1, the outer peripheral portion 2a of the first layer 2 corresponds to a region closest to the second layer 3 side. When a distance from the interface between the first layer 2 and the second layer 3 to an outer surface of the second layer 3 is divided into n equal parts (n is an integer of 2 or more) over a whole circumference to divide the second layer 3 into n regions in the cross section of the heat generation element 1, the inner peripheral portion 3a of the second layer 3 corresponds to a region closest to the first layer 2 side. Here, n is 2 (illustrated in Fig. 1), or may be 3 or more.

A shape of the heat generation element 1 is not particularly limited, and may be, for example, a wire shape, a ribbon shape, or a plate shape. A cross-sectional shape of the heat generation element 1 is not particularly limited, and may be, for example, a circular shape illustrated in Fig. 1, an elliptical shape, or a quadrangular shape.

The heat generation element 1 preferably contains tantalum, carbon and silicon as constituent elements. Silicon is mainly present in the interface portion 4. A concentration of silicon in the interface portion 4 is higher than a concentration of silicon in a portion other than the interface portion 4. When the silicon concentration in the interface portion 4 is relatively high, a degree of thermal deformation of the heat generation element 1 can be reduced. It is possible to extend a lifetime of the element and/or to improve durability against occurrence of peeling or generation of a void between layers during repeated use. In addition, when the silicon concentration in the outer peripheral portion 2a of the first layer 2 is compared with the silicon concentration in the inner peripheral portion 3a of the second layer 3 in the interface portion 4, the silicon concentration in the inner peripheral portion 3a of the second layer 3 is preferably larger than the silicon concentration in the outer peripheral portion 2a of the first layer 2.

When the silicon concentration in the interface portion 4 is higher than the silicon concentration in a portion other than the interface portion 4, the following effect is obtained. In the case of using a heat generation element partially carbonized with a hydrocarbon gas such as methane as in Patent Literature 2 or 3, when a heating time is extended, and/or when a temperature rise and fall of the heat generation element is repeated due to a repeated film formation process, a trace amount of $O_2$ (including $H_2O$ origin) in a chamber intrudes into the inside of the heat generation element at a specific temperature zone (1,600°C or more), strength decreases due to oxidative deterioration, and the heat generation element becomes unusable for the film formation process due to great deformation in some cases. On the other hand, in the heat generation element 1 according to the present embodiment, due to the presence of a large amount of silicon in the interface portion 4, $O_2$ intruding into the heat generation element is combined with Si to form $SiO_2$ and is discharged to the outside of the heat generation element 1. As a result, oxidative deterioration of the heat generation element 1 can be prevented.

When the silicon concentration in the interface portion 4 is higher than the silicon concentration in a portion other than the interface portion 4, the following effect is also obtained. In the case of using a heat generation element partially carbonized with a hydrocarbon gas such as methane as in Patent Literature 2 or 3, since a coefficient of thermal expansion is different between tantalum carbide and metallic tantalum, peeling may occur or a void may be generated around an interface between tantalum carbide and metallic tantalum when a temperature of the heat generation element repeatedly rises and falls due to a repeated film formation process. On the other hand, in the heat generation element 1 according to the present embodiment, a change in coefficient of thermal expansion around the interface between tantalum carbide and metallic tantalum becomes smooth by interposing Si around the interface, and thus it is possible to prevent the occurrence of peeling or a void generating around the interface. Since this effect may not be obtained merely by gradually changing a concentration of carbon element in the interface between tantalum carbide and metallic tantalum, interposition of Si around the interface remarkably contributes to improvement in durability of the heat generation element.

In the heat generation element 1 according to the present embodiment, a concentration of silicon in the inner peripheral portion 3a of the second layer 3 is preferably larger than a concentration of silicon in a portion other than the inner peripheral portion 3a. It is possible to further enhance an advantage of disposing high concentration silicon in the interface portion. An element concentration in the heat generation element 1 can be verified using, for example, secondary ion mass spectrometry (SIMS). The heat generation element 1 may contain other elements other than tantalum, carbon and silicon. Examples of the other elements include hydrogen or oxygen.

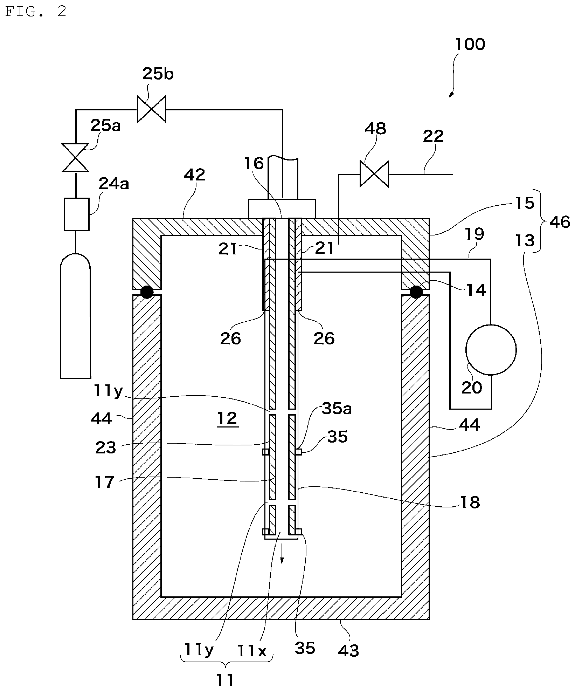

Fig. 2 is a schematic configuration diagram of a manufacturing apparatus used for a method of manufacturing the heat generation element according to the present embodiment. An apparatus 100 for manufacturing the heat generation element is a dedicated apparatus for manufacturing the heat generation element. Hereinafter, the apparatus 100 for manufacturing the heat generation element will be described with reference to Fig. 2.

The apparatus 100 for manufacturing the heat generation element includes a vacuum chamber 46, an air displacement pump (not illustrated) for evacuating the vacuum chamber 46, a gas supply pipe 23 for supplying a silicon-containing hydrocarbon gas into the vacuum chamber 46, an electrode portion 21 to which a base material 18 serving as a material of the heat generation element is attached, and a heater power supply 20 for electrifying the base material 18.

The vacuum chamber 46 has a top face wall 42, a bottom face wall 43 facing the top face wall 42, and a side face wall 44 connecting the top face wall 42 and the bottom face wall 43. The interior of the vacuum chamber 46 is a reaction chamber 12 for accommodating the base material 18 to form the heat generation element. An exhaust pipe 22 is installed to the top face wall 42 through a vacuum valve 48, and air in the reaction chamber 12 is exhausted by the air displacement pump (not illustrated). Even though Fig. 2 illustrates a form in which the vacuum chamber 46 is arranged such that the top face wall 42 is on an upper side and the bottom face wall 43 is on a lower side, arrangement is not limited thereto, and for example, the vacuum chamber 46 may be arranged such that the top face wall 42 is on the lower side, and the bottom face wall 43 is on the upper side.

The gas supply pipe 23 has a gas passage 17 and a gas port 11 communicating with the gas passage 17, and is disposed inside the reaction chamber 12. For example, the gas port 11 corresponds to a bottom face side gas port 11x for ejecting gas toward the bottom face wall 43 or a side face side gas port 11y for ejecting gas toward the side face wall 44 of the reaction chamber 12. In the present embodiment, it is preferable that at least the bottom face side gas port 11x is included as the gas port 11. More preferably, as illustrated in Fig. 2, both the bottom face side gas port 11x and the side face side gas port 11y are included as the gas port 11.

One end of the gas supply pipe 23 is connected to a gas supply port 16. Even though Fig. 2 illustrates a form in which the gas supply port 16 is provided on the top face wall 42 as an example, the invention is not limited thereto, and the gas supply port 16 may be provided on the bottom face wall 43 or the side face wall 44 (not illustrated). Gas is supplied from a cylinder to the gas supply port 16 through a gas flow rate regulator 24a and a valve 25a, and is injected from the gas port 11 through the gas passage 17. Even though Fig. 2 illustrates a form in which one gas supply pipe 23 is disposed, the invention is not limited thereto, and a plurality of gas supply pipes 23 may be disposed.

The electrode portion 21 is disposed in the reaction chamber 12. The electrode portion 21 is preferably disposed along a surface on the gas supply pipe 23 side. For example, the electrode portion 21 is electrically connected to the heater power supply 20 through an electric wire 19.

The apparatus 100 for manufacturing the heat generation element is not limited to the form illustrated in Fig. 2, and corresponds to, for example, a form in which a plurality of wire rods is used as the base material 18 and the plurality of wire rods is disposed in parallel from the top face wall 42 across the bottom face wall 43 in the manufacturing apparatus 100 illustrated in Fig. 2, or a form in which a plurality of sets of the gas supply pipe 23 and the base material 18 is disposed.

Next, a description will be given of the method of manufacturing the heat generation element according to the present embodiment. The method of manufacturing the heat generation element according to the present embodiment includes an installation step of installing the base material 18 containing tantalum as a main component in the vacuum chamber 46 and a heating step of introducing silicon-containing hydrocarbon gas into the vacuum chamber 46, heating the base material 18 installed in the vacuum chamber 46, and introducing a silicon atom from an outer surface of the base material 18 into the base material 18. When compared to a case in which the heat generation element is processed from arrangement in which tantalum and other components are stacked on the base material in advance, the heat generation element having a plurality of layers according to the invention can be rapidly and economically manufactured by providing a silicon component as a gas component from the outside.

(Installation step)

The base material 18 is a material serving as a material of the heat generation element. A shape of the base material 18 is appropriately selected according to the shape of the heat generation element. Fig. 2 illustrates a form in which the base material 18 has a wire shape as an example. For example, a material of the base material 18 is tantalum, a tantalum-based alloy, or a tantalum or tantalum-based alloy containing an additive. In the tantalum-based alloy, for example, it is preferable that metal forming the alloy with tantalum is at least one of tungsten, niobium, iridium, chromium, hafnium and molybdenum. The tantalum-based alloy preferably contains tantalum in an amount of 80 atom% or more. The additive contained in tantalum or the tantalum-based alloy is, for example, an oxide such as zirconia, yttria, calcia, silica, etc. An addition amount of the additive is preferably 1% by mass or less.

In the installation step, an upper chamber 15 is raised to connect the base material 18 to the electrode portion 21. Thereafter, the upper chamber 15 is lowered to seal the vacuum chamber 46. The base material 18 is preferably disposed along a side surface of the gas supply pipe 23. Even though Fig. 2 illustrates a form in which the base material 18 is arranged parallel to an outer peripheral surface of a side wall of the gas supply pipe 23, the invention is not limited thereto, and for example, the base material 18 may be disposed in a spiral shape on the outer peripheral surface of the side wall of the gas supply pipe 23. As illustrated in Fig. 2, the base material 18 is preferably disposed along the side surface of the gas supply pipe 23 from the connecting portion 26, turns at a predetermined place to form a return portion, and returns toward the connecting portion 26. Further, the base material 18 may be supported by a support member 35 made of an insulating material such as insulating ceramics provided on an outer periphery of the gas supply pipe 23.

(Heating step)

After the installation step, a vent (not illustrated) is closed, the air displacement pump (not illustrated) is operated, and the air in the reaction chamber 12 is exhausted by opening the vacuum valve 48. Subsequently, silicon-containing hydrocarbon gas is introduced from the gas supply pipe 23 while exhausting the inside of the reaction chamber 12, thereby adjusting the interior of the vacuum chamber 46 to a predetermined pressure. The predetermined pressure is preferably 100 Pa or less, more preferably 10 Pa or less, and still more preferably 1.5 Pa or less. In addition, a lower limit of the pressure in the vacuum chamber 46 is not particularly limited. When the pressure exceeds 100 Pa, heat resistance measures of the manufacturing apparatus tends to be excessive. In addition, dust generated in the heating step adheres to the heat generation element and the chamber, which tends to be a cause of trouble. These tendencies become more prominent as the temperature is lower. The pressure in the chamber is preferably 1 Pa or more. When the inside of the chamber becomes less than 1 Pa, a time for manufacturing the heat generation element tends to be long.

In addition, in the method of manufacturing the heat generation element according to the present embodiment, it is preferable to remove impurity gas such as water vapor, oxygen, nitrogen, etc. adhering to the inside of the vacuum chamber 46 in the heating step. Examples of a method of removing the impurity gas include a method of using a chamber in which surface roughness (Ra) of an inner wall surface is set within a predetermined range as the vacuum chamber 46, or a method of performing so-called baking treatment before the heating step. The surface roughness (Ra) per square mm of an inner wall surface of the vacuum chamber 46 is preferably 0.1 mm or less, more preferably 0.05 mm or less. Alternatively, the method of removing the impurity gas may correspond to a method of keeping the vacuum chamber 46 under vacuum at all times using a known load lock system, and performing management such that the inside of the vacuum chamber is not exposed to the atmosphere in a step of loading and unloading the base material or the processed heat generation element with respect to the inside of the vacuum chamber 46.

At least one of silicon-containing hydrocarbons may be used alone or in combination of two or three or more types for treatment of the heat generation element. In addition, an inert gas such as argon or nitrogen may be used as a carrier gas, or a reducing gas such as hydrogen may be used in combination as an additive gas. For example, an organosilane compound such as silicon tetrachloride, hexamethyldisilane, vinyltrimethylsilane, methylsilane, dimethylsilane, trimethylsilane, vinylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane methyltriethoxysilane, etc., an organosiloxane compound such as octamethylcyclotetrasiloxane, 1,1,3,3-tetramethyldisiloxane, tetraethoxysilane, hexamethyldisiloxane, etc. or an organosilazane compound such as hexamethylsilazane is used as the silicon-containing hydrocarbon. In addition to these materials, aminosilane, etc. may be used. Among these silicon-containing hydrocarbons, an organosilane compound not containing oxygen or nitrogen as a constituent element is preferable, and vinylsilane, dimethylsilane, trimethylsilane, tetramethylsilane are particularly preferable in that a proportion of carbon is higher than that of silicon in constituent elements and in terms of ease of use at the time of processing the heat generation element since the elements may be treated as gas at normal temperature and pressure.

In the heating step, a method of heating the base material 18 is not particularly limited, and for example, corresponds to a heating method using electrical heating or a heating method using a heating furnace. A timing of starting to heat the base material 18 does not matter before or after supply of the silicon-containing hydrocarbon gas.

In the method of manufacturing the heat generation element according to the present embodiment, the base material 18 has a wire shape or a ribbon shape, and the base material 18 installed in the vacuum chamber 46 is preferably electrified and heated in the heating step. Since heating of the base material is easy, it is possible to rapidly and economically manufacture the heat generation element, and to obtain the heat generation element which is easily applied to the heat generation element CVD method. For example, a sintering method or a coating method may be considered as a method of manufacturing the heat generation element having a stacked structure illustrated in Fig. 1, and the manufacturing method is complex and it is difficult to ensure quality and economic efficiency when the heat generation element having the stacked structure is manufactured using the sintering method or the coating method in a case in which the heat generation element has the wire shape or the ribbon shape. For this reason, it is efficient to use a tantalum wire or a tantalum ribbon as the base material and carburize a surface of the base material. However, when carburizing is performed using a heating furnace, the inside of the furnace needs to be kept at a high temperature, and it is difficult to construct a suitable furnace. Therefore, it is possible to manufacture a heat generation element containing Si therein using a simple apparatus by manufacturing the heat generation element using electrifying and heating.

A temperature at which the base material 18 is heated is preferably 1,600°C or more and less than 2,400°C, more preferably 1,850°C or more and less than 2,350°C, and still more preferably 2,000°C or more and 2,200°C or less. The heat generation element is rapidly manufactured, and practicality is easily verified. When the heating temperature is excessively high, the heat resistance measures of the manufacturing apparatus tend to be excessive. In addition, when the heating temperature is excessively low, it takes a longer time to manufacture the heat generation element, and an operation of verifying whether a property is suitable for the heating temperature used in the heat generation element CVD method is additionally required. In addition, the heating time is appropriately set such that a proportion of the second layer 3 (illustrated in Fig. 1) in the whole heat generation element 1 is within a desired range depending on each condition such as the material, the shape, or the size of the base material 18, the type or the supply amount of the silicon-containing hydrocarbon gas, etc. When the base material 18 is a metallic tantalum wire having a diameter of 100 to 1,000 μm, the heating time is 500 seconds or more and 3,000 seconds or less, and more preferably more than 900 seconds and 2,400 seconds or less.

In the heating step, by silicon-containing carbonized gas brought into contact with the surface of the base material 18 that has generated heat, carbonization of tantalum proceeds from the surface of the base material 18, a silicon atom is introduced into the base material 18 from the outer surface of the base material 18, and the base material 18 becomes the heat generation element 1 (illustrated in Fig. 1).

The heating step is preferably performed before the base material 18 is used as the heat generation element. By performing in this way, it is possible to use the heat generation element in a state of high strength from a first film forming process, and the durability can be further improved.

So far, a method of carburizing using a gas has been described as the method of manufacturing the heat generation element however, the heat generation element may be manufactured by the sintering method or the coating method. In the sintering method, for example, paste containing tantalum powder, silicon powder, and carbon powder is applied and sintered sequentially on the surface of the base material containing tantalum as a main component. In addition, examples of the coating method include a method of sequentially applying a coating solution containing silicon and tantalum carbide on the surface of the base material containing tantalum as a main component and drying the coating solution, or a method of stacking a layer containing silicon and tantalum on the surface of the base material using sputtering, etc.

A description will be given of an example of a method of using the heat generation element 1. The heat generation element 1 according to the present embodiment is suitably used as a heat generation element of the heat generation element CVD method. Since the heat generation element 1 according to the present embodiment has high durability, it is possible to maintain a state before use even when film formation is repeated, for example, 2,000 times.

Examples

Next, even though a description will be given using examples of the invention, the invention is not limited to these examples.

(Example 1)

A heat generation element was manufactured using the apparatus 100 illustrated in Fig. 2. In this instance, a metallic tantalum wire having a diameter of 500 μm was installed as the base material 18 in the vacuum chamber 46, vinylsilane was introduced as a silicon-containing hydrocarbon gas at 25 cc (standard state)/min while the inside of the vacuum chamber 46 was evacuated to adjust the inside of the vacuum chamber 46 to 1.5 Pa, and the base material 18 disposed in the vacuum chamber 46 was electrified and heated for 1,800 seconds at a temperature of 2,100 to 2,180°C, thereby obtaining the heat generation element. A carburization thickness (a distance from the outer surface of the second layer to an inner surface of the first layer, hereinafter also referred to as a thickness of the second layer) was in a range of 130 to 180 $\mu$m (a minimum value to a maximum value). The carburization thickness was measured by determining a center position on a C component image of SIMS and measuring a length from the outer surface of the second layer toward the center in a cross section.

(Example 2)

A heat generation element was manufactured in the same manner as in Example 1 except that the heating time of the base material 18 was changed to 900 seconds. The carburization thickness (the thickness of the second layer) was in a range of 50 to 80 $\mu$m (a minimum value to a maximum value). The carburization thickness was measured in the same manner as in Example 1.

(Example 3)

A heat generation element was manufactured in the same manner as in Example 1 except that the heating temperature of the base material 18 was changed to 1,900 to 2,000°C. The carburization thickness (the thickness of the second layer) was in a range of 40 to 50 $\mu$m (a minimum value to a maximum value). The carburization thickness was measured in the same manner as in Example 1.

(Comparative Example 1)

A metallic tantalum wire having a diameter of 500 $\mu$m was used as a heat generation element.

(Comparative Example 2)

A heat generation element was manufactured in the same manner as in Example 1 except that vinylsilane was changed to acetylene, and the heating time was changed to 5,400 seconds. The carburization thickness (the thickness of the second layer) was in a range of 130 to 180 $\mu$m (a minimum value to a maximum value). The carburization thickness was measured in the same manner as in Example 1.

(Comparative Example 3)

A heat generation element was manufactured in the same manner as in Example 1 except that vinylsilane was changed to methane, and the heating time was changed to 8,100 seconds. The carburization thickness (the thickness of the second layer) was in a range of 130 to 180 $\mu$m (a minimum value to a maximum value). The carburization thickness was measured in the same manner as in Example 1.

(Evaluation of durability)

A step of supplying vinylsilane gas as a material gas at 25 cc (standard state)/min for five seconds while the heat generation element was caused to generate heat at 2,000 to 2,200°C by application thereto after the inside of the vacuum chamber was depressurized up to 1.5 Pa in a state in which the heat generation element of each of Examples and Comparative Examples was installed using the apparatus 100 for manufacturing the heat generation element illustrated in Fig. 2 was repeated every 30 seconds. Electrifying of the heat generation element and supply of the material gas were terminated after this repeated heating step was carried out 2,000 times, leak gas was introduced to bring the inside of the vacuum chamber to atmospheric pressure after the inside of the vacuum chamber was evacuated, and a state of the heat generation element was visually observed after taking out the heat generation element. In addition, the heat generation element was removed from the manufacturing apparatus, and a central portion of an end portion on a side attached to the electrode portion and a return portion of the heat generation element (in respective Examples and Comparative Examples, a length from the end portion on the side attached to the electrode portion to the return portion of the heat generation element was 160 mm, and the central portion was a portion 80 mm away from the return portion) was pinched with fingers and shaken in air space with a wrist, thereby confirming strength. Evaluation criteria are as described below. Evaluation results are shown in Table 1.
○: Almost no deformation is observed in the heat generation element after the repeated heating step (a position change of each part compared to before the repeated heating step is 2 mm or less), and the heat generation element may withstand use in the film forming apparatus. Alternatively, break or crack is not caused even when the heat generation element is pinched with fingers and shaken (practical use level).
△: Even though slight deformation is observed in the heat generation element after the repeated heating step (a position change of each part compared to before the repeated heating step is more than 2 mm and 4 mm or less), use in the film forming apparatus is allowed. Alternatively, break or crack is not caused even when the heat generation element is pinched with fingers and shaken (practical use lower limit level).

×: The heat generation element after the repeated film formation is greatly deformed (a position change of each part compared to before the repeated heating step exceeds 4 mm), and thus can not be used in the film forming apparatus. Alternatively, break or crack is caused when the heat generation element is pinched with fingers and shaken (practical use inappropriate level).

[Table 1]

|  | Type of gas | Heating temperature | Heating time | Evaluation of durability |
|---|---|---|---|---|
| Example 1 | Vinylsilane | 2100~2180°C | 1800 seconds | ○ |
| Example 2 | Vinylsilane | 2100~2180°C | 900 seconds | Δ |
| Example 3 | Vinylsilane | 1900~2000°C | 1800 seconds | Δ |
| Comparative Example 1 | n/a | n/a | n/a | × |
| Comparative Example 2 | Acetylene | 2100~2180°C | 5400 seconds | × |
| Comparative Example 3 | Methane | 2100~2180°C | 8100 seconds | × |

(Observation of state after repeated film formation)

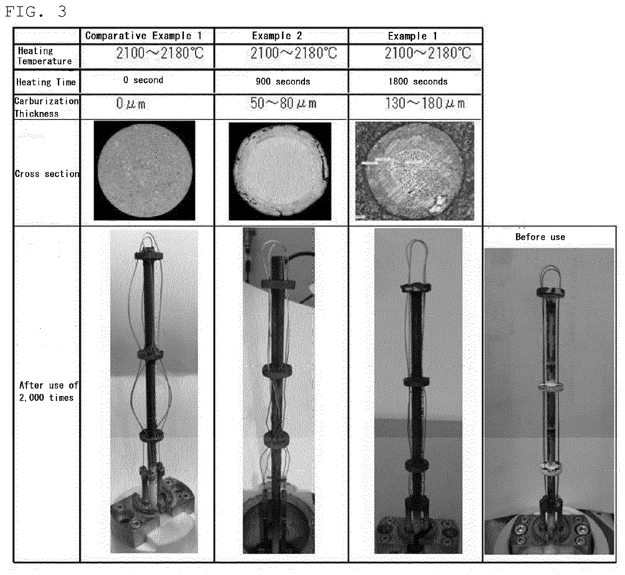

With regard to the heat generation elements of Example 1, Example 2 and Comparative Example 1, an appearance of the heat generation element after film formation was repeated 2,000 times was observed. Photographs are shown in Fig. 3.

(Observation of cross section)

With regard to the heat generation elements of Example 1, Example 2 and Comparative Example 1, a cross-sectional state was confirmed with a magnification of 400 times using an optical microscope. Optical micrographs are shown in Fig. 3.

(SIMS)

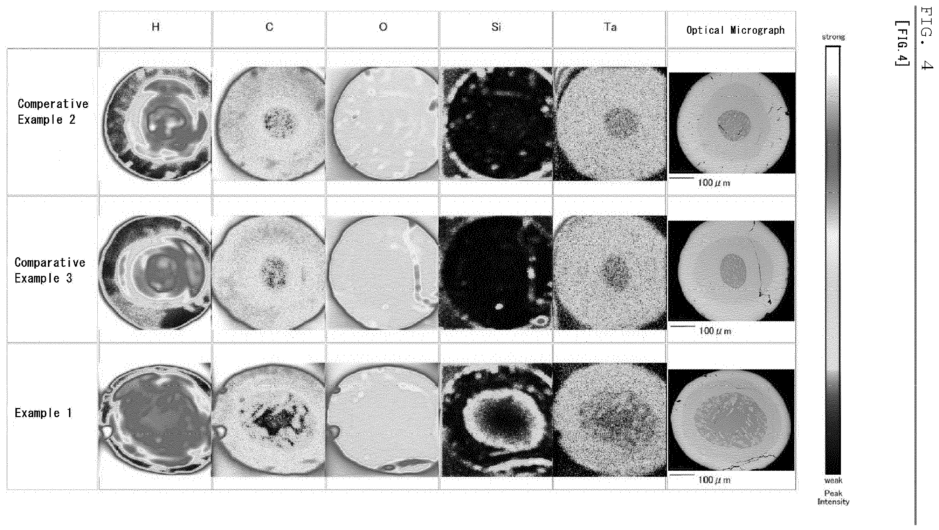

H, C, O, Si and Ta concentrations in cross sections of Example 1, Comparative Example 2 and Comparative Example 3 were confirmed using SIMS. Analysis results are shown in Fig. 4. Even though Fig. 4 shows an image obtained by processing a distribution of each element to gray gradation, the distribution of each element is more accurately expressed by a color image before processing to gray gradation.

As shown in Fig. 4, in Example 1, silicon was present in the interface portion between the first layer and the second layer, and the concentration of silicon in the interface portion was higher than the concentration of silicon at a portion other than the interface portion. In Example 2 and Example 3, an element distribution was the same as in Example 1. In addition, as shown in Table 1, each Example showed excellent durability in heating repeated 2,000 times. As shown in Fig. 3, in Example 1, the appearance of the heat generation element hardly changed from a state before use after repeating heating 2,000 times. In Example 2, even though slight deformation of the heat generation element was observed after repeating heating 2,000 times, the deformation was suppressed to such an extent as to withstand the use in the film forming apparatus.

In addition, referring to Fig. 4, depending on the positional relationship of high concentration regions of Si and C components, in Example 1, the concentration of silicon in the inner peripheral portion of the second layer was confirmed to be higher than the concentration of silicon in a portion other than the inner peripheral portion.

Meanwhile, as shown in Fig. 4, even though Comparative Example 2 and Comparative Example 3 had the first layer and the second layer, silicon was not present in the interface portion. In addition, as shown in Table 1, durability was not obtained in each Comparative Example in film formation repeated 2,000 times. As shown in Fig. 3, in Comparative Example 1, the heat generation element was greatly deformed after film formation repeated 2,000 times, and was in a state in which the heat generation element can not withstand use in the film forming apparatus.

(Bending strength)

Bending strengths of Example 1, Comparative Example 2, and Comparative Example 3 having carburization thicknesses of 130 to 180 $\mu$m were compared to one another. The bending strengths were measured in accordance with "8.3 bending strength" of JIS S 6005:2007 "lead for a mechanical pencil" by replacing "lead" with "heat generation element". That is, a load was applied to the central portion of the heat generation element supported between both fulcrums, the load at the time of breakage of the heat generation element was measured, and the bending strength was calculated by an equation below (Formula 1). Two heat generation elements were prepared for each of Example 1, Comparative Example 2, and Comparative Example 3, and experiments were carried out (n = 1, 2). A distance between both fulcrums was set to 30 mm, method I was applied to a method of applying a load, and a load speed was set to 0.1 N/s. Shapes (radius R) of a distal end at which a load is applied and distal ends of the both fulcrums were set to R = 0.2 $\pm$ 0.02 mm. Evaluation results are shown in Table 2.

$$[\text{Formula 1}]$$

$$\sigma = \frac{8Fl}{\pi d^3}$$

Here,

$\sigma$: Bending strength (MPa)
$F$ : Load (N)
$l$ : distance between fulcrums (mm)
$d$ : diameter of heat generation element (mm)

[Table 2]

| | Type of gas | Heating temperature | Heating time | Bending strength[Mpa] | |
|---|---|---|---|---|---|
| | | | | n=1 | n=2 |
| Example 1 | Vinylsilane | 2100~2180°C | 1800 seconds | 917.1 | 1021.1 |
| Comparative Example 2 | Acetylene | 2100~2180°C | 5400 seconds | 431.8 | 533.9 |
| Comparative Example 3 | Methane | 2100~2180°C | 8100 seconds | 189.8 | 163.7 |

As shown in Table 2, Example 1 had greater bending strength than that of Comparative Example 2 and Comparative Example 3. When this result is compared with the SIMS analysis result shown in Fig. 4, it was possible to confirm that a heat generation element having large bending strength is obtained by having a configuration in which silicon exists in the interface portion between the first layer and the second layer, and the concentration of silicon in the interface portion is higher than the concentration of silicon at a portion other than the interface portion.

(Example 4)

A heat generation element was manufactured in the same manner as in Example 1 except that vinylsilane was changed to monomethylsilane. The carburization thickness (the thickness of the second layer) was in a range of 40 to 50 $\mu$m (a minimum value to a maximum value). The carburization thickness was measured in the same manner as in Example 1.

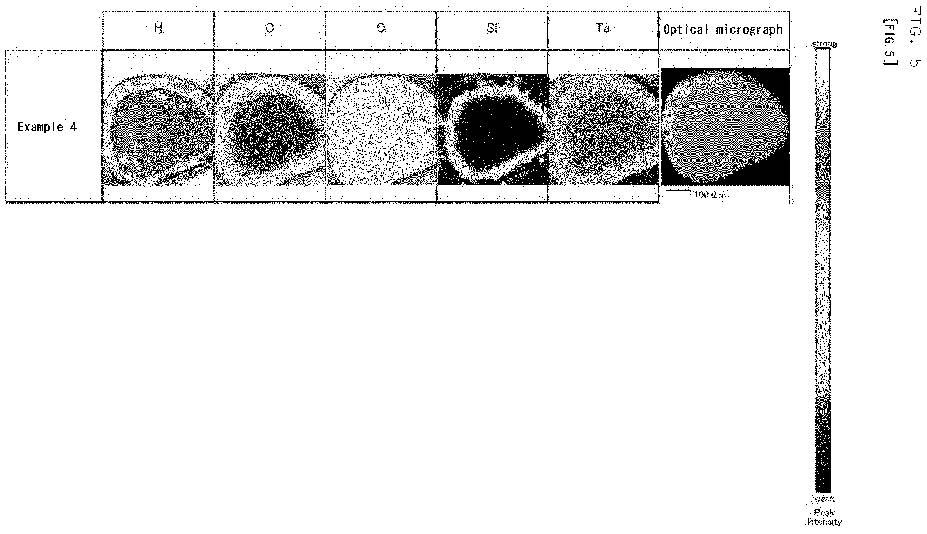

H, C, O, Si and Ta concentrations in a cross section of Example 4 were confirmed using SIMS. An analysis result is shown in Fig. 5. Even though Fig. 5 shows an image obtained by processing a distribution of each element to gray gradation, the distribution of each element is more accurately expressed by a color image before processing to gray gradation.

As shown in Fig. 5, in Example 4, silicon was present in the interface portion between the first layer and the second layer, and the concentration of silicon in the interface portion was higher than the concentration of silicon at a portion other than the interface portion. In addition, referring to Fig. 5, depending on the positional relationship of high concentration regions of Si and C components, in Example 4, the concentration of silicon in the inner peripheral portion of the second layer was confirmed to be higher than the concentration of silicon in a portion other than the inner peripheral portion.

Reference Signs List

1       Heat generation element
2       First layer
2a      Outer peripheral portion of first layer
3       Second layer
3a      Inner peripheral portion of second layer
4       Interface portion
11      Gas port
11x     Bottom face side gas port
11y     Side face side gas port
12      Reaction chamber
16      Gas supply port
17      Gas passage
18      Base material
19      Electric wire
20      Heater power supply
21      Electrode portion
22      Exhaust pipe
23      Gas supply pipe
24a     Gas flow rate regulator
25a     Valve
26      Connecting portion
35      Support member
42      Top face wall
43      Bottom face wall
44      Side face wall
46      Vacuum chamber
48      Vacuum valve
100     Apparatus for manufacturing heat generation element

**Claims**

1.   A heat generation element comprising:

     a first layer corresponding to a core of the heat generation element and having a metallic tantalum phase; and
     a second layer which covers a periphery of the first layer and has a tantalum carbide phase,
     wherein an interface portion is a region including an outer peripheral portion of the first layer and an inner peripheral portion of the second layer, a concentration of silicon in the interface portion is higher than a concentration of silicon in a portion other than the interface portion.

2.   The heat generation element according to claim 1, wherein a concentration of silicon in an inner peripheral portion of the second layer is larger than a concentration of silicon in a portion other than the inner peripheral portion.

3.   The heat generation element according to claim 1 or 2, wherein a ratio of a cross-sectional area of the first layer to a cross-sectional area of the heat generation element is 0.07 or more and 0.64 or less.

4.   A method of manufacturing the heat generation element according to any of claims 1 to 3, the method comprising:

     an installation step of installing a base material containing tantalum as a main component in a vacuum chamber; and
     a heating step of introducing a silicon-containing hydrocarbon gas into the vacuum chamber, heating the base material installed in the vacuum chamber, and introducing a silicon atom from an outer surface of the base material into an inside of the base material,
wherein the base material is heated at a temperature of 1,600°C or more and less than 2,400°C in the heating step and the heating time is 500 seconds or more and 3,000 seconds or less.

5. The method of manufacturing a heat generation element according to claim 4,
wherein the base material has a wire shape or a ribbon shape, and
the base material installed in the vacuum chamber is electrified and heated in the heating step.

**Patentansprüche**

1. Wärmeerzeugungselement, umfassend:

eine erste Schicht, die einem Kern des Wärmeerzeugungselements entspricht und eine metallische Tantalphase aufweist; und
eine zweite Schicht, die einen Umfang der ersten Schicht bedeckt und eine Tantalcarbidphase aufweist,
wobei ein Grenzflächenabschnitt ein Bereich ist, der einen äußeren Umfangsabschnitt der ersten Schicht und einen inneren Umfangsabschnitt der zweiten Schicht umfasst, und die Konzentration von Silizium in dem Grenzflächenabschnitt höher ist als die Konzentration von Silizium in einem anderen Abschnitt als dem Grenzflächenabschnitt.

2. Wärmeerzeugungselement gemäß Anspruch 1, wobei die Konzentration von Silizium in einem inneren Umfangsabschnitt der zweiten Schicht größer ist als die Konzentration von Silizium in einem anderen Abschnitt als dem inneren Umfangsabschnitt.

3. Wärmeerzeugungselement gemäß Anspruch 1 oder 2, wobei das Verhältnis einer Querschnittsfläche der ersten Schicht zu einer Querschnittsfläche des Wärmeerzeugungselements 0,07 oder mehr und 0,64 oder weniger beträgt.

4. Verfahren zur Herstellung des Wärmeerzeugungselements gemäß einem der Ansprüche 1 bis 3, wobei das Verfahren umfasst:

einen Montageschritt, bei dem ein Basismaterial, das Tantal als Hauptkomponente enthält, in einer Vakuumkammer montiert wird; und
einen Erwärmungsschritt, bei dem ein siliziumhaltiges Kohlenwasserstoffgas in die Vakuumkammer eingeführt wird, das in der Vakuumkammer montierte Basismaterial erwärmt wird, und ein Siliziumatom von einer äußeren Oberfläche des Basismaterials in das Innere des Basismaterials eingeführt wird,
wobei das Basismaterial in dem Erwärmungsschritt auf eine Temperatur von 1.600°C oder mehr und weniger als 2.400°C erwärmt wird und die Erwärmungszeit 500 Sekunden oder mehr und 3.000 Sekunden oder weniger beträgt.

5. Verfahren zur Herstellung eines Wärmeerzeugungselements gemäß Anspruch 4,
wobei das Basismaterial eine Drahtform oder eine Bandform aufweist, und
das in der Vakuumkammer montierte Basismaterial in dem Erwärmungsschritt unter Strom gesetzt und erwärmt wird.

**Revendications**

1. Elément de génération de chaleur comprenant :

une première couche correspondant à un noyau de l'élément de génération de chaleur et présentant une phase de tantale métallique ; et
une seconde couche qui recouvre une périphérie de la première couche et présente une phase de carbure de tantale,
dans lequel une partie d'interface est une région incluant une partie périphérique externe de la première couche et une partie périphérique interne de la seconde couche, une concentration de silicium dans la partie d'interface est supérieure à une concentration de silicium dans une partie autre que la partie d'interface.

2. Elément de génération de chaleur selon la revendication 1, dans lequel une concentration de silicium dans une partie périphérique interne de la seconde couche est supérieure à une concentration de silicium dans une partie autre que la partie périphérique interne.

**3.** Elément de génération de chaleur selon la revendication 1 ou 2, dans lequel un rapport d'une section transversale de la première couche à une section transversale de l'élément de génération de chaleur est de 0,07 ou plus et de 0,64 ou moins.

**4.** Procédé de fabrication de l'élément de génération de chaleur selon l'une quelconque des revendications 1 à 3, le procédé comprenant :

une étape d'installation d'un matériau de base contenant du tantale en tant qu'un composant principal dans une chambre à vide; et

une étape de chauffage d'introduction d'un gaz d'hydrocarbure contenant du silicium dans la chambre à vide, de chauffage du matériau de base installé dans la chambre à vide, et d'introduction d'un atome de silicium d'une surface externe du matériau de base dans un intérieur du matériau de base,

dans lequel le matériau de base est chauffé à une température de 1600 °C ou plus et de moins de 2 400°C dans l'étape de chauffage et le temps de chauffage est de 500 secondes ou plus et de 3 000 secondes ou moins.

**5.** Procédé de fabrication d'un élément de génération de chaleur selon la revendication 4,

dans lequel le matériau de base présente une forme de fil ou une forme de ruban, et

le matériau de base installé dans la chambre à vide est électrifié et chauffé dans l'étape de chauffage.

FIG. 1

FIG. 2

FIG. 3

| | Comparative Example 1 | Example 2 | Example 1 | |
|---|---|---|---|---|
| Heating Temperature | 2100~2180℃ | 2100~2180℃ | 2100~2180℃ | |
| Heating Time | 0 second | 900 seconds | 1800 seconds | |
| Carburization Thickness | 0 μm | 50~80 μm | 130~180 μm | |
| Cross section | | | | |
| After use of 2,000 times | | | | Before use |

FIG. 4

[FIG.4]

FIG. 5

[FIG.5]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012091095 A
- JP 2012041576 A
- JP 2005068002 A

- JP 2010530604 W
- EP 2660353 A1
- EP 2660049 A1